# EUROPEAN PATENT APPLICATION

(11) **EP 3 979 495 A1**
(43) Date of publication of application: **06.04.2022**
(21) Application number: 20813725.7
(22) Date of filing: 24.04.2020
(51) Int. Cl.: H03H 3/02, H03H 9/02, H03H 9/25

(54) **RESONATOR HAVING MULTILAYER PROTRUSION STRUCTURE AND MANUFACTURING METHOD THEREFOR, FILTER, AND ELECTRONIC DEVICE**

(30) Priority: 31.05.2019 CN 201910473085
(71) Applicant: Tianjin University, Tianjin 300072 (CN); Rofs Microsystem (Tianjin) Co., Ltd, Tianjin 300462 (CN)
(72) Inventor: ZHANG, Menglun, Tianjin 300072 (CN); PANG, Wei, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/086559
(87) International publication number: WO 2020/238509

(57) **Abstract**

A bulk acoustic wave resonator, comprising: a substrate; an acoustic mirror; a bottom electrode, provided on the substrate; a top electrode (50), opposite to the bottom electrode and having an electrode connection portion; and a piezoelectric layer (40), provided on the bottom electrode and between the bottom electrode and the top electrode (50). At least a first protrusion structure (52) and a second protrusion structure (53) stacked in the thickness direction of the substrate are provided at the edge of the top electrode (50); the first protrusion structure (52) is disposed on the top electrode (50), and the second protrusion structure (53) is disposed on the first protrusion structure (52); the first protrusion structure (52) has a first width (W1), the second protrusion structure (53) has a second width (W2), and the ratio of the first width (W1) to the second width (W2) is in a range of 7:1 to 9:7. Also provided are a filter and an electronic device having the filter. Also provided is a manufacturing method for the bulk acoustic wave resonator, comprising the steps: selecting the first width (W1) of the first protrusion structure (52) and the second width (W2) of the second protrusion structure (53), so that the ratio of the first width (W1) to the second width (W2) is in a range of 7:1 to 9:7.

## Description

### TECHNICAL FIELD

Embodiments of the present disclosure relate to the field of semiconductors, in particular to a bulk acoustic wave resonator and a manufacturing method thereof, a filter having the resonator, and electronic equipment having the filter.

### BACKGROUND

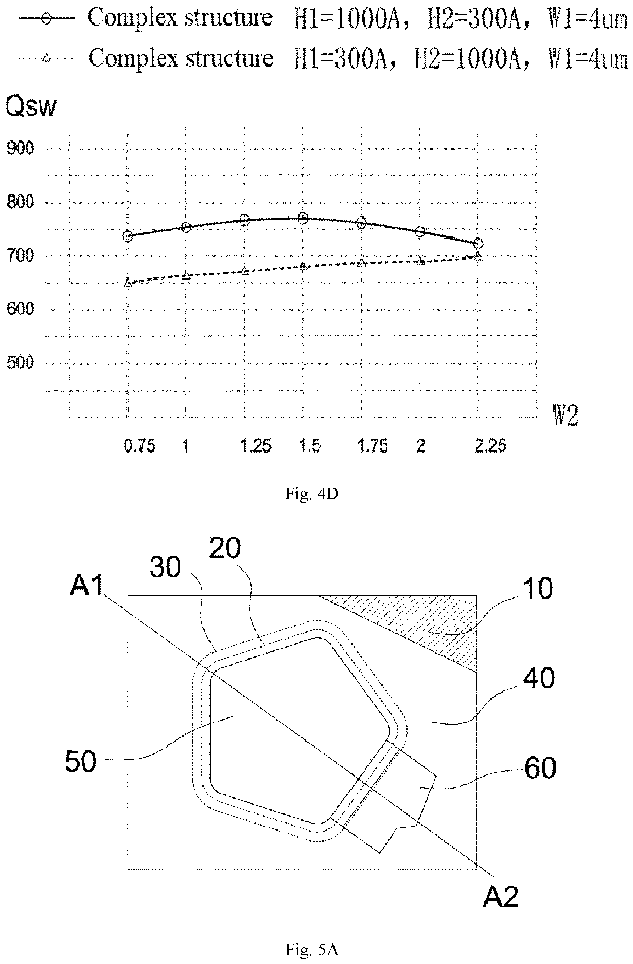

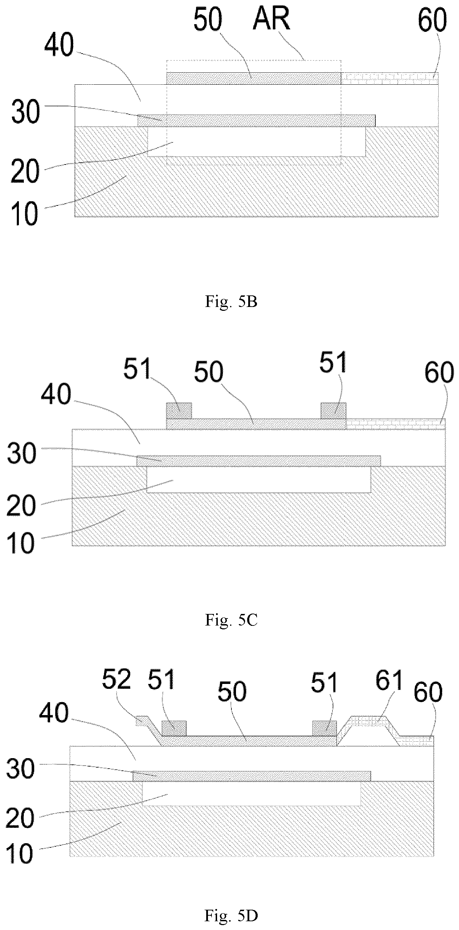

Fig. 5A is a top view of a bulk acoustic resonator in the prior art, and Fig. 5B is a schematic diagram of a sectional structure along line A1-A2 shown in Fig. 5A. In Fig. 5A and Fig. 5B, the structures corresponding to the reference signs are described as follows:
10: Substrate;
20: Acoustic mirror, which is a cavity in this example, and may be a Bragg reflection layer or other equivalent acoustic-wave reflection structures;
30: Bottom electrode;
40: Piezoelectric film (piezoelectric layer);
50: Top electrode;
60: Top electrode pin; and
AR: Effective acoustic region (acousto-electric coupling region).

Structures not shown in Fig. 5A and Fig. 5B further include a part of auxiliary process layer, a protective layer, a bottom electrode pin, and the like.

In an actual working state, the AR region of the resonator shown in Fig. 5A and Fig. 5B not only produces useful vibration in piston mode, but also produces unfavorable laterally propagating acoustic waves which may be propagated beyond the AR region, resulting in energy loss of the resonator and a decrease in the performance. This further reduces the performance of electronic devices using this type of resonators, such as the deterioration of insertion loss, roll-off, bandwidth and other key performance parameters of a filter.

Fig. 5C illustrates a resonator structure for suppressing acoustic wave leakage in the prior art. Compared with the structure in Fig. 5B, the resonator structure is improved in that a protrusion structure is provided on the edge of the top electrode 50 and the protrusion structure forms an acoustic impedance mismatch region on the edge of the AR region. In this way, the acoustic waves that are propagated laterally outward from the AR region may be reflected back to the AR region, thereby suppressing the energy loss.

Fig. 5D illustrates another resonator structure for suppressing acoustic wave leakage in the prior art. Compared with the structure in Fig. 5C, the resonator structure is improved in that in addition to providing the protrusion structure on the edge of the top electrode 50, the top electrode 50 further extends outwards to form an air wing, and meanwhile, the pin 60 also forms an arched structure (hereinafter collectively referred to as a suspension wing structure).

The protrusion structures shown in Fig. 5C and Fig. 5D have the disadvantages that the acoustic wave reflection ability is insufficient and the acoustic wave reflection performance is sensitive to size.

### SUMMARY

In order to overcome at least one aspect of the technical defects in the prior art, the present disclosure is provided.

According to one aspect of embodiments of the present disclosure, a bulk acoustic wave resonator is provided and includes: a substrate; an acoustic mirror; a bottom electrode provided above the substrate; a top electrode arranged opposite to the bottom electrode and provided with an electrode connection portion; and a piezoelectric layer provided above the bottom electrode and arranged between the bottom electrode and the top electrode, wherein: an edge of the top electrode is provided with at least a first protrusion structure and a second protrusion structure, which are stacked in a thickness direction of the substrate, the first protrusion structure is arranged on the top electrode, and the second protrusion structure is arranged on the first protrusion structure; and the first protrusion structure has a first width, the second protrusion structure has a second width, and a ratio of the first width to the second width is within a range of 7:1 to 9:7. Further, the ratio of the first width to the second width is within a range of 4:1 to 2:1.

Optionally, the second width is within a range of 0.5-3 µm, and further within a range of 1-2 µm; or the second width is within a range of 1.5-9 µm, and further within a range of 3-6 µm.

Optionally, the second width is within a range of 0.5-3 µm and further within a range of 1-2 µm, and the first width is within a range of 1-6 µm and further within a range of 2-5 µm; or the second width is within a range of 1.5-9 µm and further within a range of 3-6 µm, and the first width is within a range of 3-18 µm and further within a range of 6-15 µm.

Optionally, the second width is in a range of ± 1 µm of a period low value corresponding to the first protrusion structure, the first width is in a range of ± 2 µm of a period high value corresponding to the first protrusion structure, and the period high value is greater than the period low value. Further optionally, the second width is within a range of (a)±1 µm in which a is an adjacent period low value corresponding to the first protrusion structure, and the first width is with a range of (b)±2 µm in which b is an adjacent period high value corresponding to the first protrusion structure. Optionally, the ratio of the second width to the first width is about 1:3, or 3:5, or 5:7. Further, the adjacent period low value is 1.25 µm, and the adjacent period high value is 4 µm.

Optionally, outer sides of the first protrusion structure and the second protrusion structure are substantially aligned with the edge of the top electrode.

Optionally, the edge of the top electrode is provided with a suspension wing structure or a bridge structure.

Optionally, the resonator further includes a first extension layer and a second extension layer, the first extension layer extends from the first protrusion structure toward the corresponding suspension wing structure or bridge structure to cover the suspension wing structure or bridge structure, and the second extension layer extends from the second protrusion structure toward the corresponding suspension wing structure or bridge structure to cover the first extension layer.

Optionally, the resonator further includes a passivation layer covering at least the first protrusion structure and the second protrusion structure.

Optionally, a first thickness of the first protrusion structure is greater than a second thickness of the second protrusion structure.

Optionally, a ratio of the second thickness to the first thickness is within a range of 1:1.1 to 1:10, and further within a range of 1:3 to 1:8. Further, the first thickness is within a range of 300-5000 Å and further within a range of 500-2000 Å, and the second thickness is within a range of 50-3000 Å and further within a range of 400-1000 Å.

Optionally, an inner side edge of the first protrusion structure is closer to the inner side than an inner side edge of the second protrusion structure.

According to another aspect of embodiments of the present disclosure, a filter is provided and includes the above bulk acoustic wave resonator.

According to still another aspect of embodiments of the present disclosure, electronic equipment is provided and includes the above filter or the above bulk acoustic wave resonator.

Embodiments of the present disclosure further relate to a method of manufacturing a bulk acoustic wave resonator. The resonator includes: a substrate; an acoustic mirror; a bottom electrode provided above the substrate; a top electrode arranged opposite to the bottom electrode and provided with an electrode connection portion; a piezoelectric layer provided above the bottom electrode and arranged between the bottom electrode and the top electrode; and at least a first protrusion structure and a second protrusion structure provided on the edge of the top electrode and stacked in a thickness direction of the substrate, wherein the first protrusion structure is arranged on the top electrode, and the second protrusion structure is arranged on the first protrusion structure. The method includes selecting a first width of the first protrusion structure and a second width of the second protrusion structure in such a manner that a ratio of the first width to the second width is within a range of 7:1 to 9:7.

### BRIEF DESCRIPTION OF DRAWINGS

The following description and drawings may help understand these and other features and advantages in various embodiments disclosed in the present disclosure. The same reference signs in the drawings always indicate the same components, wherein:
Fig. 1A is a schematically partial sectional view of a film bulk acoustic wave resonator according to an exemplary embodiment of the present disclosure;
Fig. 1B is a schematically partial sectional view of a film bulk acoustic wave resonator according to an exemplary embodiment of the present disclosure;
Fig. 1C is a schematically partial sectional view of a film bulk acoustic wave resonator according to an exemplary embodiment of the present disclosure;
Fig. 2A is a schematically partial sectional view of a film bulk acoustic wave resonator according to an exemplary embodiment of the present disclosure;
Fig. 2B is a schematically partial sectional view of a film bulk acoustic wave resonator according to an exemplary embodiment of the present disclosure;
Fig. 3A is a schematically partial sectional view of a film bulk acoustic wave resonator according to an exemplary embodiment of the present disclosure, in which a thickness of a first protrusion structure is greater than a thickness of a second protrusion structure;
Fig. 3B is a schematic diagram showing the variation of the relationship between the Rp value of the resonator and widths of the protrusion structures in a double-layer protrusion structure according to the present disclosure and a traditional single-layer protrusion structure;
Fig. 3C is a schematically partial sectional view of a film bulk acoustic wave resonator according to an exemplary embodiment of the present disclosure, in which the thickness of the first protrusion structure is less than the thickness of the second protrusion structure;
Fig. 3D schematically shows the influence of the protrusion structures in Fig. 3C on an electrical performance curve of the resonator;
Fig. 3E schematically shows the influence of the movement of a secondary resonance peak on the electrical performance curve of the resonator;
Fig. 3F schematically shows the influence of the movement of the secondary resonance peak on a Q curve in a Smith chart;
Fig. 3G is an exemplary schematic diagram showing the comparison between the influence of different thickness ratios of the first protrusion structure and the second protrusion structure on the Rp value and the influence of the single-layer protrusion structure on the Rp value;
Fig. 4A is an exemplary schematic diagram showing the comparison of the Rp performance of resonators with the double-layer protrusion structure and the single-layer protrusion structure varying with a second width W2;
Fig. 4B is an exemplary schematic diagram showing the comparison of the Rp performance of resonators with the double-layer protrusion structure and the single-layer protrusion structure varying with a first width W1;
Fig. 4C is an exemplary schematic diagram showing the comparison of the robustness of resonators with different double-layer protrusion structures varying with the second width W2;
Fig. 4D is an exemplary schematic diagram showing the comparison of Qsw values of resonators with different double-layer protrusion structures varying with the second width W2;
Fig. 5A is a top view of a bulk acoustic resonator in the prior art;
Fig. 5B is a schematic diagram of a sectional structure along line A1-A2 shown in Fig. 5A;
Fig. 5C is a resonator structure for suppressing acoustic wave leakage in the prior art;
Fig. 5D is another resonator structure for suppressing acoustic wave leakage in the prior art;
Fig. 5E is a partial sectional view of a bulk acoustic resonator with a single-layer protrusion structure in the prior art; and
Fig. 5F is a curve diagram showing the Rp performance of the resonator with the protrusion structure in Fig. 5E varying with the width of the protrusion structure.

### DESCRIPTION OF EMBODIMENTS

The technical solutions of the present disclosure will be further described below in detail through embodiments and in conjunction with the drawings. The following description of the embodiments of the present disclosure with reference to the drawings is intended to explain the general inventive concept of the present disclosure, and should not be construed as a limitation to the present disclosure.

Hereinafter, a bulk acoustic resonator according to an embodiment of the present disclosure will be described with reference to the drawings. It should be noted that in the embodiment of the present disclosure, although a film bulk acoustic resonator is described as an example, these descriptions may be applied to other types of bulk acoustic resonators.

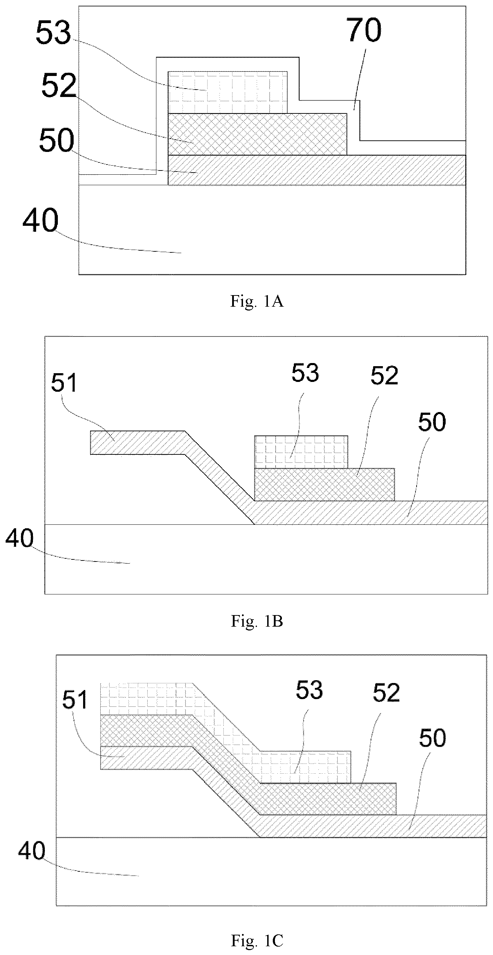

Fig. 1A illustrates a structure of an edge portion of a top electrode according to an embodiment of the present disclosure, in which a double-layer protrusion structure is provided. In Fig. 1A, a top electrode 50 is located on a piezoelectric layer 40, a first protrusion structure 52 is located on an upper surface of an edge of the top electrode, and a second protrusion structure 53 is located on an upper surface of the first protrusion structure. A passivation layer 70 may cover the above structures to prevent the surrounding environment from corroding the resonator (the passivation layer 70 is only shown in this figure and is omitted in the subsequent embodiments).

Specifically, components and materials in Fig. 1A are described as follows.

The top electrode 50 is made of a metal material. The metal material may be selected from molybdenum, ruthenium, gold, aluminum, magnesium, tungsten, copper, titanium, iridium, osmium, chromium, or a combination thereof or their alloys.

The protrusion structures 52, 53 may be made of non-metallic materials, such as silicon dioxide, silicon nitride, silicon carbide, aluminum nitride, magnesium oxide, aluminum oxide, or other metal oxides or nitrides or polymers. The protrusion structures may be made of metal materials same as or different from that of the top electrode, such as molybdenum, ruthenium, gold, aluminum, magnesium, tungsten, copper, titanium, iridium, osmium, chromium, or a combination thereof or their alloys. The two protrusion structures are made of the same material or different materials.

The passivation layer 70 is an optional protective layer, which can prevent moisture, oxygen or other foreign substances from corroding the resonator (this layer is omitted and not illustrated in the subsequent embodiments). The protective layer may be made of a non-metallic material, such as silicon dioxide, silicon nitride, silicon carbide, aluminum nitride, magnesium oxide, aluminum oxide, or other metal oxides or nitrides or polymers.

The above description of materials can also be applied to other embodiments of the present disclosure.

In the present disclosure, the double-layer protrusion structure is also referred to as a complex protrusion structure or a complex structure (as shown in the drawings).

As shown in Fig. 1A, an inner side edge of the first protrusion structure 52 is closer to the inner side than an inner side edge of the second protrusion structure 53. In the present disclosure, the inner side is a side closer to the center of an effective region.

In the present disclosure, as shown in the figure, the first protrusion structure is wider than the second protrusion structure. The first protrusion structure has a first width, the second protrusion structure has a second width, and a ratio of the first width to the second width is within a range of 7:1 to 9:7.

As shown in Fig. 1A, outer sides of the first protrusion structure 52 and the second protrusion structure 53 are substantially aligned with the edge of the top electrode.

An electrode non-connection end in Fig. 1A extends outwards to form a suspension wing structure so that a suspension wing structure 51 and the complex protrusion structure are combined in an embodiment as shown in Fig. 1B.

Based on certain process conditions, the complex protrusion structure on the electrode non-connection end with the suspension wing structure in Fig. 1B may be in the form of an embodiment shown in Fig. 1C. That is, the first protrusion structure and the second protrusion structure extend to an upper surface of the suspension wing structure.

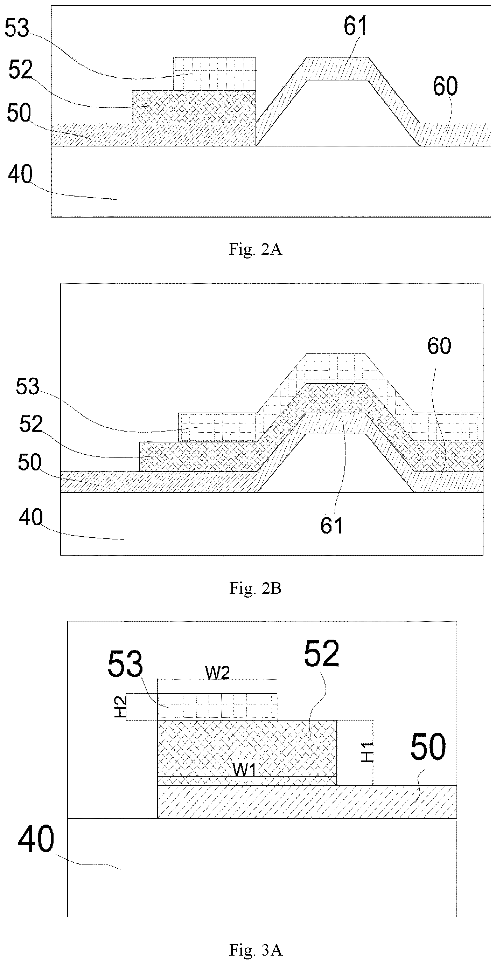

As to a connection end of the top electrode with electrode pins, the complex protrusion structure may have the structure of an embodiment as shown in Fig. 2A.

As to a process, the complex protrusion structure in Fig. 2A may extend to a surface of a pin structure 61 or even an electrode lead 60 to form the structure of the embodiment as shown in Fig. 2B.

Fig. 3A is a schematically partial sectional view of a film bulk acoustic resonator according to an exemplary embodiment of the present disclosure, in which the thickness of the first protrusion structure is greater than the thickness of the second protrusion structure.

In Fig. 3A, the first protrusion structure has a first height H1 and a first thickness

W1, and the second protrusion structure has a second thickness H2 and a second width W2. A ratio of the second thickness H2 to the first thickness H1 is within a range of 1:1.1 to 1:10, and optionally within a range of 1:3 to 1:8. For example, the second thickness H2 is within a typical numerical range of 50-3000 Å, and optionally within a range of 400-1000 Å. The first thickness H1 is within a numerical range of 300-5000 Å, and optionally within a range of 500-2000 Å. The numerical ranges of the second thickness H2 and the first thickness H1 are not limited to those in the above embodiments. In addition to the aforementioned endpoint values, for example, the first thickness H1 may be 1500 Å and the second thickness H2 may be 600 Å.

Furthermore, the numerical range of the second width W2 may be from 0.5 µm to 3 µm, and optionally from 1 µm to 2 µm. Alternatively, the numerical range of the second width W2 may be from 1.5 µm to 9 µm, and optionally from 3 µm to 6 µm. The range of the first width W1 may be from 1 µm to 6 µm, and optionally from 2 µm to 5 µm, such as 2.5 µm. Alternatively, the range of the first width W1 may be from 3 µm to 18 µm, and optionally from 6 µm to 15 µm, such as 9 µm. In an embodiment, the range of the second width W2 is from 0.5 µm to 3 µm, and optionally from 1 µm to 2 µm, such as 1.5 µm; and the range of the first width W1 is from 1 µm to 6 µm, and optionally from 2 µm to 5 µm, such as 2.5 µm. Alternatively, the range of the second width W2 is from 1.5 µm to 9 µm, and optionally from 3 µm to 6 µm, such as 4 µm; and the range of the first width W1 is from 3 µm to 18 µm, and optionally from 6 µm to 15 µm, such as 12 µm.

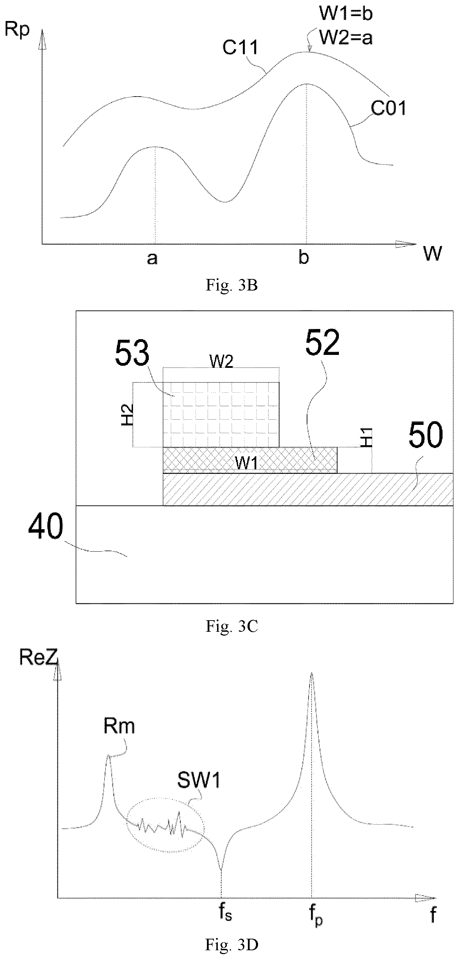

Fig. 3B is a schematic diagram showing the variation of the relationship between the Rp value of the resonator and widths of the protrusion structures in a double-layer protrusion structure according to the present disclosure and a traditional single-layer protrusion structure. In Fig. 3B, a curve C01 describes the quasi periodic change of the acoustic wave reflection ability (measured by the parallel resonance impedance Rp, and the greater value indicates the stronger reflection ability) when the width of the traditional single-layer protrusion structure changes. In Fig. 3B, a and b respectively represent the widths of the protrusion structure when the reflection ability of the traditional protrusion structure achieves a local maximum value, and respectively correspond to an adjacent period low value and an adjacent period high value of the single-layer protrusion structure which is merely provided with the first protrusion structure. A curve C11 is a quasi-periodical curve showing the acoustic wave reflection performance of the complex protrusion structure varying with the widths W1 and W2 sin Fig. 3A. The maximum value of Rp on the curve C11 shown in the figure is obtained substantially when W1=b and W2=a. Accordingly, in one embodiment of the present disclosure, the second width W2 is within a range of a±1 µm in which a is the adjacent period low value corresponding to the first protrusion structure, and the first width W1 is within a range of b±2 µm in which b is the adjacent period high value corresponding to the first protrusion structure.

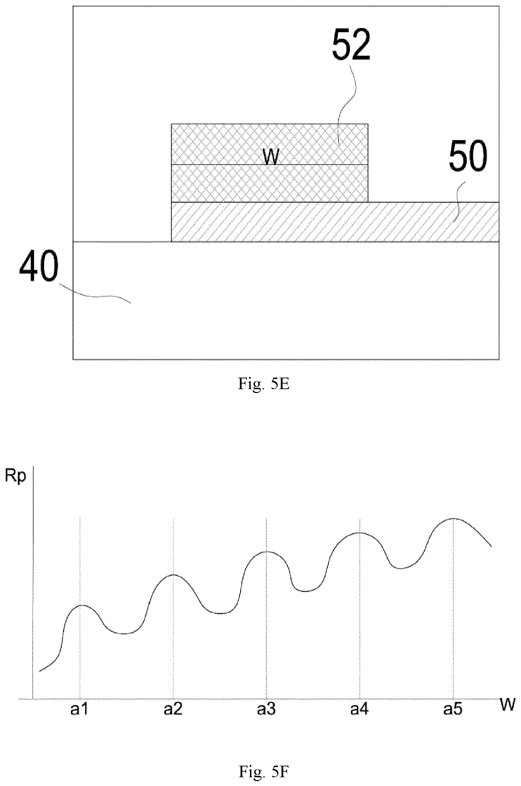

Fig. 5E is a partial sectional view of a bulk acoustic resonator with a single-layer protrusion structure in the prior art, and Fig. 5F is a curve diagram showing the Rp performance of the resonator with the protrusion structure in Fig. 5E varying with the width of the protrusion structure. In Fig. 5E, the width of the single-layer protrusion structure is W. The curve of the Rp of the traditional protrusion structure varying with the protrusion width W is shown in Fig. 5F.

As shown in Fig. 5F, local peak values of the Rp-W curve correspond to widths of the protrusion structure, such as a1, a2, a3, a4, a5, etc., which substantially satisfy a proportional relationship a1:a2:a3:a4:a5: ...=1:3:5:7:9:....

In some embodiments of the present disclosure, the ratio of the first width to the second width of the complex protrusion structure is to select 2 or more from ratios corresponding to the five adjacent peak values of the traditional protrusion structure, while ensuring that the second width is less than the first width. As to more than two layers of protrusion structures, it is ensured that widths of the protrusion structures gradually increase from top to bottom. In this way, the width ratio corresponding to two adjacent peak values may be selected, for example, w1:w2=3:1, or w1:w2=5:3, or w1:w2=7:5, or w1:w2= 9:7, or other ratio. Alternatively, the width ratio corresponding to two peak values separated by one or more peak values may be selected, for example, w1:w2=5:1 (separated by one peak value), or w1:w2=7:1 (separated by two peak values), or other ratio. As to more than two layers of protrusion structures, the width ratios corresponding to multiple adjacent peak values may be selected, such as w1:w2:w3=5:3:1, or the width ratios corresponding to the peak values may be selected in the interval mode, such as w1:w2:w3=9:5:1.

In the present disclosure, the width ratio corresponding to the selected peak values Rp is within a range of 7:1 to 9:7, and optionally within a range of 4:1 to 2:1. The width ratios of the protrusion structures is configured in the above range so that the acoustic waves achieve the optimal fluctuation and interference effect under the action of the double-layer protrusion structure. Accordingly, a stable acoustic reflection performance improvement is obtained, and the negative effects of the secondary resonance mode on the Q value near the series resonance frequency are reduced.

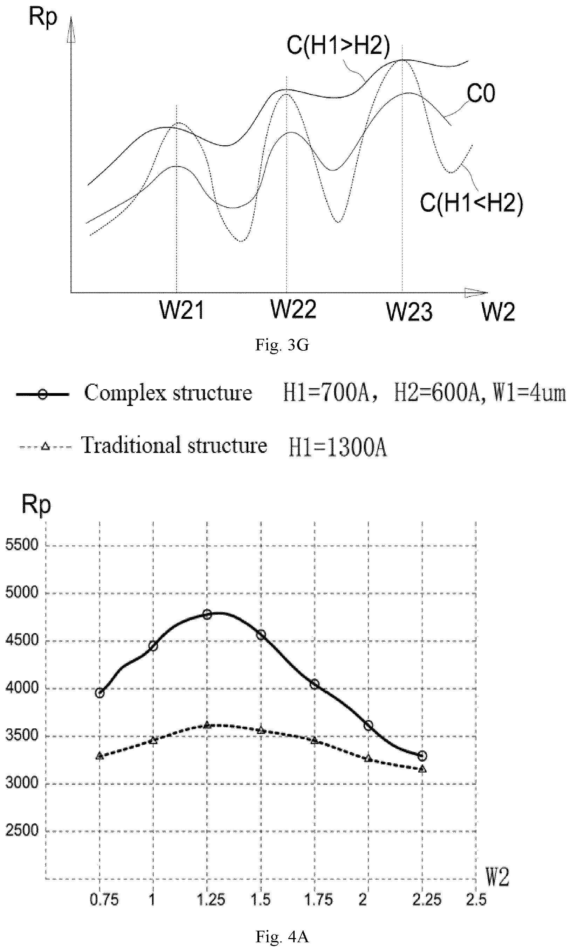

Fig. 3C is a schematically partial sectional view of a film bulk acoustic resonator according to an exemplary embodiment of the present disclosure, in which a thickness of the first protrusion structure is less than a thickness of the second protrusion structure. Fig. 3G is an exemplary schematic diagram showing the comparison between the influence of different thickness ratios of the first protrusion structure and the second protrusion structure on the Rp value and the influence of the single-layer protrusion structure on the Rp value.

Furthermore, when a first thickness H1 is greater than a second thickness H2, the influence of the second width W2 on the Rp value becomes weaker (the robustness is strong, corresponding to a curve C (H1>H2) shown in Fig. 3G). Alternatively, when the first thickness H1 is less than the second thickness H2 as shown in Fig. 3C, the sensitivity of the Rp value to the change of the second width W2 becomes stronger (the robustness is weak, corresponding to a curve C (H1<H2) shown in Fig. 3G). When the robustness of Rp is poor, a small change in the second width W2 may cause the performance of Rp to deviate from the technical indicators. Therefore, a more costly process is used in order to improve the accuracy of the second width W2. It can be seen that the solution of H1<H2 is inferior to the solution of H1>H2, which will be further described below.

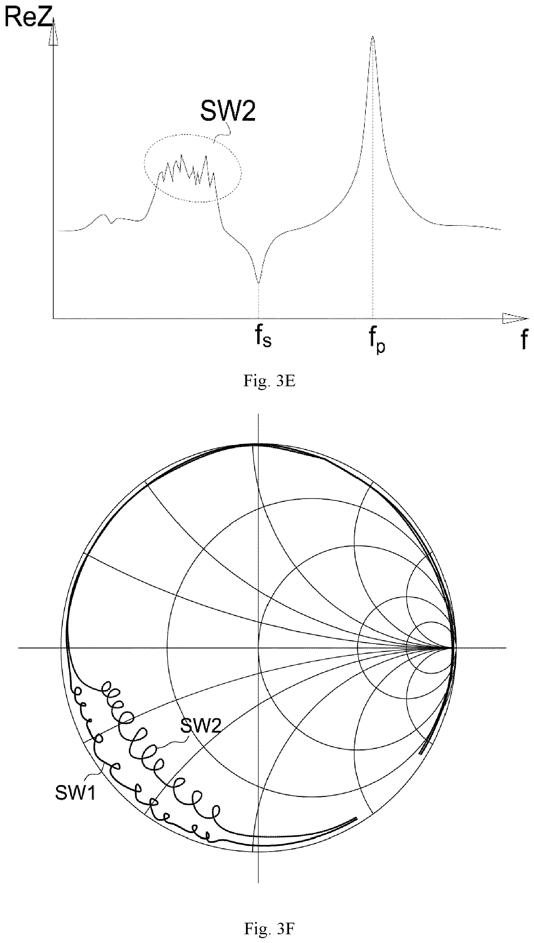

Fig. 3D schematically shows the influence of the protrusion structures in Fig. 3C on an electrical performance curve of the resonator. Fig. 3E schematically shows the influence of the movement of a secondary resonance peak on the electrical performance curve of the resonator. Fig. 3F schematically shows the influence of the movement of the secondary resonance peak on a Q curve in the Smith chart. Fig. 3G is an exemplary schematic diagram showing the comparison between the influence of different thickness ratios of the first protrusion structure and the second protrusion structure on the Rp value and the influence of the single-layer protrusion structure on the Rp value.

In addition to the influence on the robustness, the relationship between the two thicknesses H1 and H2 affects an indicator Qsw of the resonator, in which SW denotes a southwest quadrant on the Smith chart in Fig. 3F, and Qsw denotes a Q value performance in this quadrant.) This is because that the protrusion structure is provided to introduce the secondary resonance peak into the electrical performance of the resonator, as shown by Rm in Fig. 3D. Further, the spike-like fluctuations in the SW1 portion are caused by the parasitic mode. When the first thickness H1 is less than the second thickness H2, the second width W2 is reduced so as to significantly reduce the overall mass of the complex protrusion structure, which causes the resonance peak in Fig. 3D to move rightwards obviously (the mass becomes smaller, and the vibration frequency becomes higher). As a result, the resonance peak enters the southwest quadrant, thereby forming the electrical performance curve in Fig. 3E. It can be seen from Fig. 3E that, since the secondary resonance peak moves toward the right side and enters the SW region, the curve of the SW region is "lifted". This phenomenon is reflected in the Smith chart in that the Q curve in the southwest quadrant shrinks inwards (the Qsw deteriorates), and the "heterocycle" phenomenon becomes more prominent, as shown in Fig. 3F.

In view of the above description in the present disclosure, preferably, the first thickness H1 is greater than the second thickness H2 in the complex protrusion structure.

Referring to Fig. 3G, the Rp performance curves of the complex protrusion structure and the traditional single protrusion structure are compared with each other to indicate that there is substantially no difference between the highest points of the Rp curves of the two complex protrusion structures, but there is difference in the robustness. Further, the maximum Rp values of the two curves are higher than the Rp value of the traditional protrusion structure.

In an embodiment of the present disclosure, the ratio of the second thickness H2 to the first thickness H1 is within the range of 1:1.1 to 1:10, and further within the range of 1:3 to 1:8.

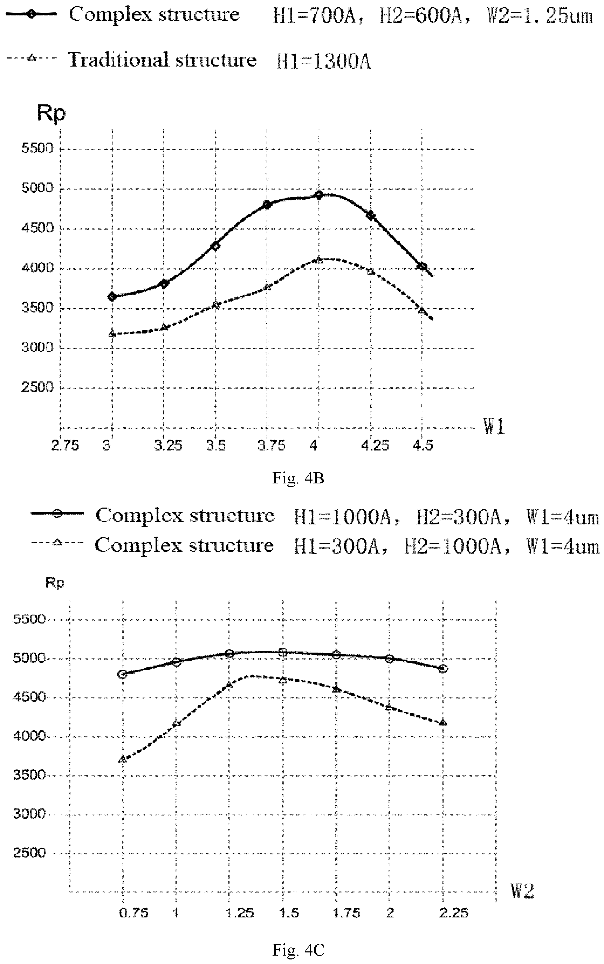

Fig. 4A is an exemplary schematic diagram showing the comparison of the Rp performance of resonators with the double-layer protrusion structure and the single-layer protrusion structure varying with the second width W2. Fig. 4B is an exemplary schematic diagram showing the comparison of the Rp performance of resonators with the double-layer protrusion structure and the single-layer protrusion structure varying with the first width W1. Fig. 4C is an exemplary schematic diagram showing the comparison of the robustness of resonators with different double-layer protrusion structures varying with the second width W2. Fig. 4D is an exemplary schematic diagram showing the comparison of Qsw values of resonators with different double-layer protrusion structures varying with the second width W2.

In Fig. 4A, in the embodiment of the complex structure or complex protrusion structure, H1 is 700A, H2 is 600 A, and W1 is 4 µm. In the traditional structure, the thickness H1 of the single-layer protrusion structure is 1300 Å. In Fig. 4A, the first width W1 of the complex protrusion structure is a fixed value of 4 µm, and a variable range of the second width W2 is from 0.75 µm to 2.25 µm. The width of the traditional protrusion structure changes synchronously with the second width W2.

In Fig. 4B, in the embodiment of the complex structure or complex protrusion structure, H1 is 700 A, H2 is 600 A, and W2 is 1.25 µm. In the traditional structure, the thickness H1 of the single-layer protrusion structure is 1300 Å. In Fig. 4B, the second width W2 of the complex protrusion structure is a fixed value of 1.25 µm, and a variable range of the first width W1 is from 3 µm to 4.5 µm. The width of the traditional protrusion structure changes synchronously with the first width W1.

Referring to Fig. 4A and Fig. 4B, the Rp value of the resonator corresponding to the complex protrusion structure is significantly greater than the Rp value of the resonator corresponding to the traditional protrusion structure.

Referring to Fig. 4A, when the Rp value of the resonator corresponding to the complex protrusion structure is constant at the second width W2, the peak value of Rp corresponds the first width W1 of 1.25 µm. In Fig. 4A, the Rp value of the resonator with the traditional single-layer protrusion structure has a peak value when the width of the protrusion structure is 1.25 µm.

Referring to Fig. 4B, when the Rp value of the resonator corresponding to the complex protrusion structure is constant at the first width W1, the peak value of Rp corresponds the second width W2 of 4 µm. In Fig. 4B, the Rp value of the resonator with the traditional single-layer protrusion structure has another peak value when the width of the protrusion structure is 4 µm.

Fig. 4A and Fig. 4B show value indicating modes of the two widths W1 and W2 of the complex protrusion structure. Specifically, the first width W1 is a width of the protrusion structure with a value of 4 µm, which corresponds to the peak value of the Rp value of the resonator with the traditional single-layer protrusion structure. The second width W2 is a width of the protrusion structure with a value of 1.25 µm, which corresponds to the peak value of the Rp value of the resonator with the traditional single-layer protrusion structure.

In addition, in Fig. 4A, the width of the protrusion structure in the resonator with the traditional single-layer protrusion structure is within a range of 0.75-2.5 µm. In Fig. 4B, the width of the protrusion structure in the resonator with the traditional single-layer protrusion structure is within a range of 2.75-4.5 µm. Obviously, the width of 1.25 µm (corresponding to a in Fig. 3B) and the width of 4 µm (corresponding to b in Fig. 3B) are the widths of the protrusion structure when the reflection ability of the traditional protrusion structure achieves the local maximum value, and respectively correspond to the adjacent period low value and the adjacent period high value of the single-layer protrusion structure only with the first protrusion structure.

In the present disclosure, although two adjacent period low value and period high value are selected as the second width and the first width, the present disclosure is not limited thereto. The period low value and the period high value may be values which are not adjacent to each other. Furthermore, in the described example, the ratio of the second width to the first width is approximately 1:3, or the ratio of the second width to the first width may be approximately 3:5 or 5:7.

Fig. 4C illustrates two embodiments of the complex structure or complex protrusion structure. In a first embodiment, H1 is 1000 Å, H2 is 300 Å, and W1 is 4 µm. In a second embodiment, H1 is 300 Å, H2 is 1000 Å, and W1 is 4 µm. It can be seen that in the first embodiment, the Rp curve is smooth, indicating that the robustness of Rp is good.

Fig. 4D illustrates two embodiments of the complex structure or complex protrusion structure. In a first embodiment, H1 is 1000 Å, H2 is 300 Å, and W1 is 4 µm. In a second embodiment, H1 is 300 Å, H2 is 1000 Å, and W1 is 4 µm. It can be seen that the Qsw in the first embodiment is greater than the Qsw in the second embodiment.

In addition, in the embodiment of the present disclosure, the first protrusion structure is arranged on the top electrode, the second protrusion structure is arranged on the first protrusion structure, and the first protrusion structure and the second protrusion structure are stacked. This is a double-layer protrusion structure, but embodiments of the present disclosure are not limited thereto. A third protrusion structure may be provided on the second protrusion structure on the basis of the double-layer protrusion structure, as long as the first protrusion structure and the second protrusion structure according to the present disclosure both fall within the scope of the present disclosure.

Based on the above description, the present disclosure provides a bulk acoustic wave resonator, which includes:
a substrate;
an acoustic mirror;
a bottom electrode provided above the substrate;
a top electrode arranged opposite to the bottom electrode and provided with an electrode connection portion; and
a piezoelectric layer provided above the bottom electrode and arranged between the bottom electrode and the top electrode,
wherein:
   an edge of the top electrode is provided with a first protrusion structure and a second protrusion structure, which are stacked in a thickness direction of the substrate, the first protrusion structure is arranged on the top electrode, the second protrusion structure is arranged on the first protrusion structure, and an inner side edge of the first protrusion structure is closer to an inner side than an inner side edge of the second protrusion structure; and
   the first protrusion structure has a first width, the second protrusion structure has a second width, and a ratio of the first width to the second width is within the range of 7:1 to 9:7.

In a further embodiment, the thickness of the first protrusion structure is greater than the thickness of the second protrusion structure. On one hand, the acoustic wave reflection ability is enhanced, and on the other hand, the robustness of the performance of the resonator to the size is improved, thereby reducing the process difficulty and the cost.

In addition, in the present disclosure, optionally, the second width is in the range of ± 1 µm of a period low value corresponding to the first protrusion structure, the first width is in the range of ± 2 µm of a period high value corresponding to the first protrusion structure, and the period high value is greater than the period low value. Further, the second width W2 may be within the range of a±1 µm in which a is the adjacent period low value corresponding to the first protrusion structure, and the first width W1 may be within the range of b±2 µm in which b is the adjacent period high value corresponding to the first protrusion structure. Therefore, it is conducive to obtaining optimal acoustic wave reflection ability or a greater Rp value.

In a further embodiment, the ratio of the second width to the first width is about 1:3, or 3:5, or 5:7. Further, the adjacent period low value is 1.25 µm, and the adjacent period high value is 4 µm.

Based on the above description, the present disclosure further provides a filter including a plurality of the above bulk acoustic resonators. The present disclosure further provides electronic equipment including the above filter or the above bulk acoustic resonator.

Correspondingly, the present disclosure provides a method of manufacturing a bulk acoustic resonator. The resonator includes: a substrate; an acoustic mirror; a bottom electrode provided above the substrate; a top electrode arranged opposite to the bottom electrode and provided with an electrode connection portion; a piezoelectric layer provided above the bottom electrode and arranged between the bottom electrode and the top electrode; and a first protrusion structure and a second protrusion structure, which are provided on an edge of the top electrode and are stacked in a thickness direction of the substrate, wherein the first protrusion structure is arranged on the top electrode, and the second protrusion structure is arranged on the first protrusion structure. The method includes selecting a first width of the first protrusion structure and a second width of the second protrusion structure so that the ratio of the first width to the second width is within the range of 7:1 to 9:7.

In the above method, the second width is selected to be within the range of (a)±1 µm in which a is the adjacent period low value corresponding to the first protrusion structure, and the first width is selected to be within the range of (b)±2 µm in which b is the adjacent period high value corresponding to the first protrusion structure.

Further, the ratio of the second width to the first width is selected to be about 1:3, or 3:5, or 5:7.

Further, the adjacent period low value is 1.25 µm, and the adjacent period high value is 4 µm.

The first protrusion structure has a first thickness, and the second protrusion structure has a second thickness. The method further includes selecting the ratio of the second thickness to the first thickness to be within the range of 1:1.1 to 1:10, further within the range of 1:3 to 1:8.

Although the embodiments of the present disclosure have been illustrated and described, those of ordinary skill in the art can understand that modifications can be made to these embodiments without departing from the principle and spirit of the present disclosure, and the scope of the present disclosure is defined by the appended claims and their equivalents.

## Claims

1. A bulk acoustic wave resonator, comprising:
a substrate;
an acoustic mirror;
a bottom electrode provided above the substrate;
a top electrode arranged opposite to the bottom electrode and provided with an electrode connection portion; and
a piezoelectric layer provided above the bottom electrode and arranged between the bottom electrode and the top electrode,
wherein an edge of the top electrode is provided with at least a first protrusion structure and a second protrusion structure that are stacked in a thickness direction of the substrate, the first protrusion structure is arranged on the top electrode, and the second protrusion structure is arranged on the first protrusion structure; and
wherein the first protrusion structure has a first width, the second protrusion structure has a second width, and a ratio of the first width to the second width is within a range of 7:1 to 9:7.

2. The resonator according to claim 1, wherein the second width is within a range of 0.5-3 µm, and further within a range of 1-2 µm; or
the second width is within a range of 1.5-9 µm, and further within a range of 3-6 µm.

3. The resonator according to claim 1, wherein the second width is within a range of 0.5-3 µm and further within a range of 1-2 µm, and the first width is within a range of 1-6 µm and further within a range of 2-5 µm; or
the second width is within a range of 1.5-9 µm and further within a range of 3-6 µm, and the first width is within a range of 3-18 µm and further within a range of 6-15 µm.

4. The resonator according to claim 1, wherein the second width is in a range of ± 1 µm of a period low value corresponding to the first protrusion structure, the first width is in a range of ± 2 µm of a period high value corresponding to the first protrusion structure, and the period high value is greater than the period low value.

5. The resonator according to claim 4, wherein the second width is within a range of (a)±1 µm in which a is an adjacent period low value corresponding to the first protrusion structure, and the first width is within a range of (b)±2 µm in which b is an adjacent period high value corresponding to the first protrusion structure.

6. The resonator according to any one of claims 1-5, wherein the ratio of the second width to the first width is about 1:3, or 3:5, or 5:7.

7. The resonator according to claim 6, wherein the adjacent period low value is 1.25 µm, and the adjacent period high value is 4 µm.

8. The resonator according to claim 1, wherein the ratio of the first width to the second width is within a range of 4:1 to 2:1.

9. The resonator according to any one of claims 1-8, wherein outer sides of the first protrusion structure and the second protrusion structure are substantially aligned with the edge of the top electrode.

10. The resonator according to any one of claims 1-9, wherein the edge of the top electrode is provided with a suspension wing structure or a bridge structure.

11. The resonator according to claim 10, further comprising:
a first extension layer extending from the first protrusion structure toward the corresponding suspension wing structure or bridge structure to cover the suspension wing structure or the bridge structure; and
a second extension layer extending from the second protrusion structure toward the corresponding suspension wing structure or bridge portion structure to cover the first extension layer.

12. The resonator according to any one of claims 1-11, further comprising:
a passivation layer covering at least the first protrusion structure and the second protrusion structure.

13. The resonator according to any one of claims 1-12, wherein a first thickness of the first protrusion structure is greater than a second thickness of the second protrusion structure.

14. The resonator according to claim 13, wherein a ratio of the second thickness to the first thickness is within a range of 1:1.1 to 1:10, and further within a range of 1:3 to 1:8.

15. The resonator according to claim 14, wherein the first thickness is within a range of 300-5000 Å, and further within a range of 500-2000 Å; and
the second thickness is within a range of 50-3000 Å, and further within a range of 400-1000 Å.

16. The resonator according to claim 1, wherein an inner side edge of the first protrusion structure is closer to the inner side than an inner side edge of the second protrusion structure.

17. A filter, comprising the bulk acoustic wave resonator according to any one of claims 1-16.

18. An electronic equipment, comprising the filter according to claim 17 or the bulk acoustic wave resonator according to any one of claims 1-16.

19. A method of manufacturing a bulk acoustic wave resonator, wherein the resonator comprises: a substrate; an acoustic mirror; a bottom electrode provided above the substrate; a top electrode arranged opposite to the bottom electrode and provided with an electrode connection portion; a piezoelectric layer provided above the bottom electrode and arranged between the bottom electrode and the top electrode; and at least a first protrusion structure and a second protrusion structure provided on an edge of the top electrode and stacked in a thickness direction of the substrate, wherein the first protrusion structure is arranged on the top electrode, the second protrusion structure is arranged on the first protrusion structure, and
wherein the method comprises:
selecting a first width of the first protrusion structure and a second width of the second protrusion structure in such a manner that a ratio of the first width to the second width is within a range of 7:1 to 9:7.

20. The method according to claim 19, wherein the second width is selected to be within a range of (a)±1 µm in which a is an adjacent period low value corresponding to the first protrusion structure, and the first width is selected to be within a range of (b)±2 µm in which b is an adjacent period high value corresponding to the first protrusion structure.

21. The method according to claim 20, wherein the ratio of the second width to the first width is selected to be about 1:3, or 3:5, or 5:7.

22. The method according to claim 21, wherein the adjacent period low value is 1.25 µm, and the adjacent period high value is 4 µm.

23. The method according to claim 19, wherein the first width of the first protrusion structure and the second width of the second protrusion structure are selected in such a manner that the ratio of the first width to the second width is within a range of 4:1 to 2:1.

24. The method according to any one of claims 19-23, wherein the first protrusion structure has a first thickness, and the second protrusion structure has a second thickness; and
the method further comprises selecting a ratio of the second thickness to the first thickness to be within a range of 1:1.1 to 1:10, further within a range of 1:3 to 1:8.
